# EUROPEAN PATENT APPLICATION

(11) **EP 3 133 410 A1**
(43) Date of publication of application: **22.02.2017**
(21) Application number: 16184808.0
(22) Date of filing: 18.08.2016
(51) Int. Cl.: G01R 31/317

(54) **IMPROVED RESOLUTION TIMING**

(30) Priority: 21.08.2015 GB 201514936
(71) Applicant: Calnex Solutions Ltd, West Lothian EH49 7LR (GB)
(72) Inventor: WAINWRIGHT, Simon, Linlithgow, West Lothian EH49 7LR (GB); ORR, James, Linlithgow, West Lothian EH49 7LR (GB)
(74) Representative: McGlashan, Graham Stewart

(57) **Abstract**

A system for improving signal timing measurement resolution for an asynchronous measurement signal, the system being adapted to produce multiple phase shifted timing outputs, each having a fixed phase and being representative of timing information for the asynchronous measurement signal, and combine the multiple phase shifted timing outputs to provide a single combined timing output. Preferably but not essentially, the system is configured to produce the multiple phase shifted timing outputs using multiple fixed phase shifted clocks; multiple counters each one associated with one of the phase shifted clocks; and multiple samplers each one associated with one of the phase shifted clocks and its counter, wherein each clock, counter and sampler combination is used to sample the asynchronous measurement signal to produce a timing output, thereby to provide multiple phase shifted timing outputs.

## Description

### Field of the Invention

The present invention relates to a method for increasing the resolution of clock based measurements, such as wander measurements. In particular, the invention relates to packet switched network in-line testers and test methods with improved wander measurement resolution. The invention is particularly suited for implementation on a field programmable gate array (FPGA) circuit.

### Background of the Invention

Traditionally, when an FPGA measures an asynchronous signal, the measurement is made using registers clocked off the FPGA fabric clock. The frequency of that fabric clock dictates the resolution of the measurement. FPGA fabric clocks are currently limited to a few hundreds of MHz. Therefore, the resolution tends to be a few nanoseconds. For some applications, for example the measurement of wander in a telecommunications network, this intrinsic FPGA clock resolution can limit measurement accuracy.

### Summary of the Invention

According to the present invention, there is provided a system for improving signal timing measurement resolution for an asynchronous measurement signal, the system being adapted to: produce multiple phase shifted timing outputs, each representative of timing information for the asynchronous measurement signal, and combine the multiple phase shifted timing outputs to provide a single combined timing output.

A plurality or each of the multiple phase shifted timing outputs may provide a fixed phase timing output.

The system may be configured to produce the multiple phase shifted timing outputs using multiple phase shifted clocks; multiple samplers each one associated with one of the phase shifted clocks and its counter, wherein each clock and sampler combination is used to sample the asynchronous measurement signal to produce a timing output, thereby to provide multiple phase shifted timing outputs.

Each of the phase shifted clocks may be a fixed phase shifted clock, i.e. the phase of each clock may be fixed, unchangeable or non-dynamic.

The system may be configured to produce the multiple phase shifted timing outputs using multiple phase shifters for producing multiple phase shifted copies of the asynchronous measurement signal and multiple samplers, each one for sampling one of the multiple phase shifted asynchronous measurement signals to produce a phase shifted timing output, thereby to provide multiple phase shifted timing outputs. In this case, a single clock and a single counter may be used to provide timing information.

The single combined output may be produced using an adder that is configured to add the multiple timing outputs to provide the single combined timing output.

The timing output may be a duration / period of the asynchronous measurement signal.

The multiple phase shifted timing outputs may be phase shifted by 90 degrees.

Four phase shifted timing outputs may be provided.

According to another aspect of the invention, there is provided a system for improving signal timing measurement resolution comprising: multiple phase shifted clocks; multiple counters each one associated with one of the phase shifted clocks, and multiple samplers each one associated with one of the phase shifted clocks and its counter, wherein each clock, counter and sampler combination is used to sample an asynchronous measurement signal to provide a timing output, and the multiple timing outputs are combined to provide a single improved resolution timing output. The timing output may be a duration of the asynchronous measurement signal.

By using multiple phase shifted clocks the resolution of timing measurements can be improved without having to improve the absolute resolution of each individual clock. This is advantageous.

Each counter register may register changes in the measurement signal on the rising edge of its associated clock signal. Alternatively or additionally, each counter register may register changes in the measurement signal on the falling edge of its associated clock signal.

An adder may be provided, the adder being configured to add the multiple timing outputs to provide the single improved resolution timing output.

The multiple phase shifted clocks may be phase shifted by 90 degrees.

Four clocks, four counters and four samplers may be provided.

### Brief Description of the Drawings

Various aspects of the invention will be described by way of example only and with reference to the accompanying drawings, of which:
Figure 1 is block diagram of a timing / phase characteristic measurement circuit, and
Figure 2 is a timing diagram for the circuit of Figure 1.

### Detailed Description of the Drawings

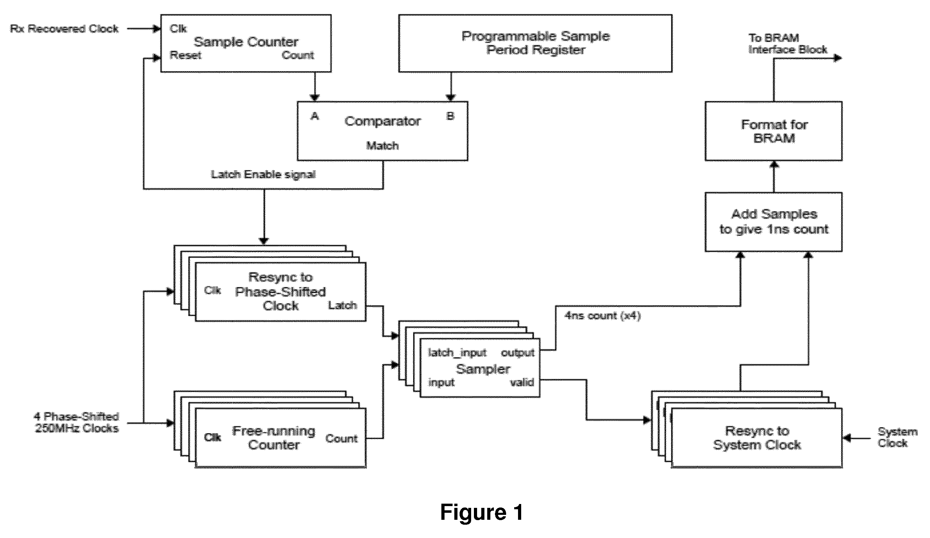

Figure 1 shows a circuit for measuring time and/or phase characteristics of a received signal. This has a sample counter that counts clock edges of a Received Recovered Clock. When this count reaches a pre-determined value (set by a Programmable Sample Period Register) it is detected by a comparator which asserts a latch enable signal, which in turn resets the sample counter. In this way, the latch enable signal is periodically generated on the Received Recovered Clock domain. The latch enable signal is fed to a plurality of Resync to Phase-Shifted Clock components, which resynchronise the latch enable signal onto each of a plurality of phase-shifted (measurement) clock domains, so that they are synchronous to the subsequent logic. Each of the phase-shifted clock domains is a fixed phase clock domain whose phase is fixed or unchanging.

On each of the phase-shifted clock domains, there is a free-running counter counting clock edges of the respective phase-shifted clock, and a sampler which samples the value of the counter whenever it receives a resynchronised latch enable signal. In Figure 1 there are 4 phase-shifted 250MHz clock domains each with a count period of 4ns. Each sample therefore has ¼ the value of a 1 ns count, so the 4 samples can be added to give a 1 ns count. The increased resolution is determined by how many of the 4 counters have incremented with respect to the others.

Each sampler also outputs a valid signal to indicate when it has output a new sample. This is resynchronised onto the System Clock domain. This indicates that the sample (on the phase-shifted clock domain) is now safe to be read on the System Clock domain. When all samples are valid (on the System Clock domain) samples are added to give 1 ns count. The Format to BRAM component is part of a system of preparing the measurement to be read in a known way, and so will not be described in detail. The measured 1ns count, triggered periodically based on the actual Rx Recovered Clock period and Programmable Sample Period Register are compared to an expected ns count, based on the Programmable Sample Period Register and the expected Rx Clock period.

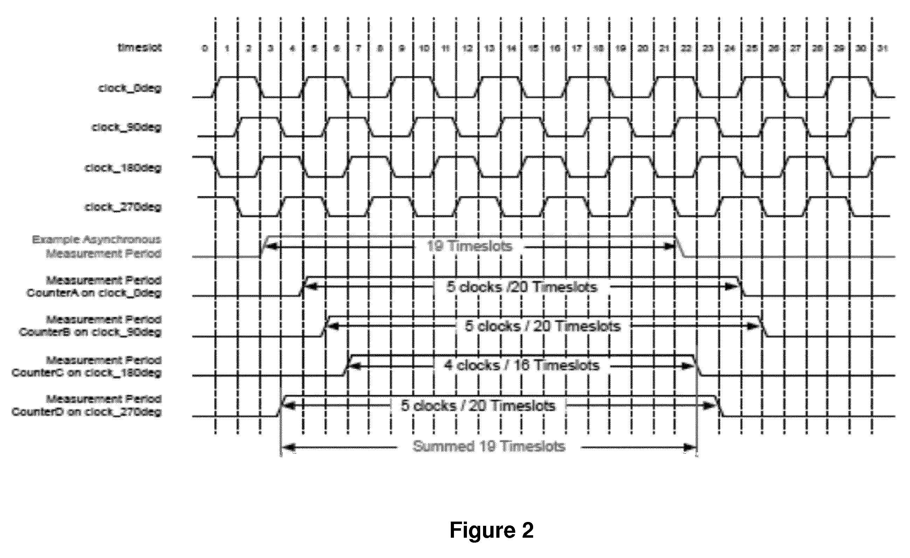

Figure 2 shows a simplified timing diagram for the circuit of Figure 1, in which four clocks are phase shifted each by 90 degrees (clock_0deg; clock_90deg; clock_180deg and clock_270deg). In the timing diagram, the four phase shifted clocks are shown along with an example asynchronous measurement period to be measured (in red). In this case, the asynchronous measurement period is the time between the latch enable signals. The example measurement period is approximately nineteen timeslots long. Each of the clocks has a clock period equal to four timeslots. The signals underneath the red measurement signal represent the period that each of the counters would measure the measurement signal. Each counter has a measurement resolution of a clock period on its individual clock domain (counterA on clock_0deg; counterB on clock_90deg; counterC on clock_180deg and counterD on clock_270deg).

This means that each counter can only count in multiples of four timeslots. Hence in the example of Figure 2, three of the counters would each measure twenty timeslots (count = 5) - see measurement periods for counterA, B and D in Figure 2 - and one would measure sixteen timeslots (count = 4) - see measurement period for counter C. Taking an average of the timeslots across all of the four registers gives an asynchronous measurement signal duration of (20+20+20+19)/4 = 19. Since the counters are each counting four timeslots, all four counters can be simply summed to get a timeslot duration of 19 ((5+5+5+4) = 19). Hence, using four counter registers and four 90deg phase shifted clocks offers an increased resolution of one timeslot. This can be done without having to improve the intrinsic resolution of any individual clock. A single measurement period per clock is shown for simplicity, but in reality this would be an N bit counter (example 64bits) and the measurement period would be calculated by subtracting the initial counter value from the final counter value to give a count of the measurement period.

The present invention provides a simple and effective means for improving the resolution of timing measurements, without requiring improvements in the intrinsic resolution of the clocks being used. This is particularly useful for the measurement of wander in, for example, a telecommunications network. It is also very useful for improving wander measurement resolution in packet switched network in-line testers and test methods.

A skilled person will appreciate that variations of the disclosed arrangements are possible without departing from the invention. For example, whilst the invention has been described with reference to phase shifted clocks and phase shifted counters, it could equally be implemented by phase shifting the asynchronous measurement signal. In this case, a single clock and a single counter would be provided, together with multiple samplers, one for each of the measurement signals. Accordingly the above description of the specific embodiment is made by way of example only and not for the purposes of limitation. It will be clear to the skilled person that minor modifications may be made without significant changes to the operation described.

## Claims

1. A system for improving signal timing measurement resolution for an asynchronous measurement signal, the system being adapted to:
produce multiple phase shifted timing outputs, each having a fixed phase and being representative of timing information for the asynchronous measurement signal, and
combine the multiple phase shifted timing outputs to provide a single combined timing output.

2. A system as claimed in claim 1 configured to produce the multiple phase shifted timing outputs using multiple phase shifted clocks; multiple counters each one associated with one of the phase shifted clocks; and multiple samplers each one associated with one of the phase shifted clocks and its counter, wherein each clock, counter and sampler combination is used to sample the asynchronous measurement signal to produce a timing output, thereby to provide multiple phase shifted timing outputs.

3. A system as claimed in claim 1 configured to produce the multiple phase shifted timing outputs using multiple phase shifters for producing multiple phase shifted copies of the asynchronous measurement signal and multiple samplers, each one for sampling one of the multiple phase shifted asynchronous measurement signals to produce a phase shifted timing output, thereby to provide multiple phase shifted timing outputs.

4. A system as claimed in any of the preceding claims wherein the single combined output is produced using an adder that is configured to add the multiple timing outputs to provide the single combined timing output.

5. A system as claimed in any of the preceding claims wherein the timing output is a duration of the asynchronous measurement signal.

6. A system as claimed in any of the preceding claims wherein the multiple phase shifted timing outputs are phase shifted by 90 degrees.

7. A system as claimed in any of the preceding claims wherein four phase shifted timing outputs are provided.

8. A system as claimed in any of the preceding claims implemented in an FPGA.

9. A system for improving signal timing measurement resolution comprising:
multiple fixed phase shifted clocks;
multiple counters each one associated with one of the phase shifted clocks;
multiple samplers each one associated with one of the phase shifted clocks and its counter,
wherein each clock, counter and sampler combination is used to sample an asynchronous measurement signal to provide a timing output, and the multiple timing outputs are combined to provide a single combined timing output.

10. A system as claimed in claim 1 wherein the timing output is a duration of the asynchronous measurement signal.

11. A system as claimed in claim 1 or claim 2 comprising an adder that is configured to add the multiple timing outputs to provide the single combined timing output.

12. A system as claimed in any of the preceding claims wherein the multiple phase shifted clocks are phase shifted by 90 degrees.

13. A system as claimed in any of the preceding claims wherein four clocks, four counters and four samplers are provided.

14. A system as claimed in any of the preceding claims implemented in an FPGA.

15. The system as claimed in any preceding claim comprised in a wander measurement system for measuring wander in a telecommunications network or other packet switched network.
